# EUROPÄISCHE PATENTANMELDUNG

(11) **EP 3 531 471 A1**
(43) Veröffentlichungstag der Anmeldung: **28.08.2019**
(21) Anmeldenummer: 19156363.4
(22) Anmeldetag: 11.02.2019
(51) Int. Cl.: H01M 2/10, H01M 2/20, H01M 10/42

(54) **AKKUPACK SOWIE ELEKTROHANDWERKZEUGGERÄT**

(30) Priorität: 26.02.2018 DE 102018104338
(71) Anmelder: Metabowerke GmbH, 72622 Nürtingen (DE)
(72) Erfinder: Stickel, Wolfgang, 72660 Beuren (DE); Stoll, Michael, 73240 Wendlingen (DE); Wolf, Alexander, 73240 Wendlingen (DE)
(74) Vertreter: Markfort, Iris-Anne Lucie

(57) **Zusammenfassung**

Die Erfindung betrifft ein Akkupack (10), insbesondere für ein Elektrohandwerkzeuggerät, mit: wenigstens zwei in Reihe oder parallel geschalteten Akkuzellen (20) und/oder Akkuzellenblöcken, einem Gehäuse mit einem Zellenträger (12) zur Aufnahme der Ackuzellen (20) und/oder Akkuzellenblöcke in übereinander angeordneten Reihen, und einer Leiterplatte (24), wobei die Akkuzellen (20) im montierten Zustand des Akkupacks (10) über Leiterbleche (22) mit der Leiterplatte (24) verbunden sind, und wobei wenigstens eines der Leiterbleche (22) im montierten Zustand des Akkupacks mit der Leiterplatte (24) zumindest abschnittsweise wenigstens zwei Leiterblechlagen (22a, 22b) umfasst.

## Beschreibung

Die vorliegende Erfindung betrifft ein Akkupack, insbesondere für ein Elektrohandwerkzeuggerät, mit wenigstens zwei in Reihe oder parallel geschalteten Akkuzellen und/oder Akkuzellenblöcken, einem Gehäuse mit einem Zellenträger zur Aufnahme der Akkuzellen in übereinander angeordneten Reihen, und einer Leiterplatte, die mit den Akkuzellen verbindbar ist.

Der Einsatz von Akkupacks zum Betrieb von Elektrohandwerkzeuggeräten hat in den vergangenen Jahren in der Praxis einen immer höheren Stellenwert eingenommen. Großer Vorteil solcher akkubetriebenen Elektrohandwerkzeuggeräte ist die höhere Flexibilität beim Arbeiten und insbesondere eine Unabhängigkeit von vorhandenen Stromquellen. Durch den Einsatz von Akkupacks kann damit insbesondere auch bei Außenarbeiten unbeschränkt von der Frage einer vorhandenen Stromquelle durchgeführt werden. Typischerweise umfassen Akkupacks mehrere in dem Gehäuse des Ackupacks aufgenommenen Akkuzellen, beispielsweise drei, vier, sechs oder acht Ackuzellen, die wiederaufladbar sind. Das Gehäuse des Akkupacks dient zur Aufnahme der Akkuzellen, aber auch zur lösbaren Verbindung mit dem Elektrohandwerkzeuggerät. Demgemäß weist das Elektrohandwerkzeuggerät üblicherweise eine Schnittstelle zur mechanischen und elektrischen Verbindung eines Akkupacks mit dem Elektrohandwerkzeuggerät auf.

Ein großer Vorteil von Akkupacks, die mittels Kühlluft aus der Umgebung gekühlt werden können (luftgekühlte Akkupacks), liegt in der besseren Leistungsabgabe der Ackupacks im Betrieb. Ein Überhitzen der Akkupacks wird hierdurch regelmäßig vorteilhaft verhindert. Hierdurch wird signifikant die Lebenszeit der Batteriezellen verlängert. Ein solches luftgekühltes Akkupack ist beispielsweise aus der Druckschrift EP 1 952 518 A1 bekannt.

In der Praxis als nachteilig bei derartigen luftgekühlten Akkupacks hat sich in der Vergangenheit gezeigt, dass die Umgebungsluft gerade bei der Bearbeitung mit spanenden Werkzeugen oftmals metallische Staub- und Schmutzpartikel enthält, die über die Belüftungsausnehmungen in das Gehäuseinnere eindringen und sich im Bereich der Pole der Akkuzellen anlagern können. Nach einiger Zeit können solche Ablagerungen im Inneren des Akkupacks zu Kurzschlüssen, beispielsweise zwischen den Akkuzellen oder im Übergangsbereich zu anderen metallischen Komponenten im Inneren des Ackupacks führen. Gleiches gilt für über die Belüftungsausnehmungen eindringendes Wasser bzw. Luftfeuchtigkeit, das zudem zu Korrosion führen kann

Es hat sich in der Praxis grundsätzlich als vorteilhaft erwiesen, die Akkuzellen eines Akkupacks beabstandet zueinander anzuordnen, um das Risiko von Kurzschlüssen zu verringern. Diesbezüglich wird unter anderem auf die Druckschrift EP 1 927 147 B1 verwiesen.

Weiterhin ist es aus dem Stand der Technik bekannt, die Akkuzellen eines Akkupacks zum Schutz vor eindringendem Wasser und Staub in einem nach außen hin abgedichteten Gehäuse aufzunehmen. So offenbart die Druckschrift EP 3 051 608 A1 eine Lösung für eine wiederaufladbare Batterieeinheit mit einem nach außen hin abgedichteten Batteriegehäuse. Nachteilig bei dieser Lösung ist jedoch wiederum, dass die Ackuzellen im Inneren des abgedichteten Akkugehäuses nicht luftgekühlt sind und dementsprechend schnell überhitzen können. Akkupacks ohne Luftkühlung besitzen eine schlechtere Leistungsabgabe und geringere Lebensdauer.

In aller Regel ist es vorgesehen, die Akkuzellen untereinander bzw. Akkuzellenblöcke untereinander in Reihe zu schalten. Für die Reihenschaltung werden zum Teil sogenannte Leiterbleche (auch als Leiterfahnen bekannt) verwendet, die die jeweiligen komplementären Pole einer Akkuzelle miteinander verbinden.

Eine solche Ausgestaltung für eine Batterie ist beispielsweise aus der DE 94 04 070.2 bekannt, die einen Batteriesatz beschreibt, bei dem einzelne Batterien in batterieaufnehmenden Zellen angeordnet sind, wobei Leiterbleche verwendet werden, die zur Verbindung und Reihenschaltung der einzelnen Batterien miteinander dienen. Die Leiterbleche sind herbei gemäß der Beschreibung bogenförmig angeordnet.

Weitere bekannte Lösungen sind in den Druckschriften US 2013/0136965 A1, DE 10 2016 200 961 A1 und DE 10 2010 002 938 A1 gezeigt.

Darüber hinaus ist es bekannt, bei Lithiumionenakkus, bei denen der Ladezustand und der Aufladevorgang über die Elektronik des Akkupacks überwacht werden soll, vorzusehen, dass die einzelnen Akkuzellen zur Überwachung ihrer Zellen mit der Elektronik verbunden sind. Hierzu können im Stand der Technik beispielsweise Litzen vorgesehen sein, die die Akkuzellen mit der Elektronikeinheit und hier insbesondere der Leiterplatte verbinden.

Eine in der Praxis wichtige Komponente eines Akkupacks ist in diesem Zusammenhang eine elektrische Sicherung, die in der Regel an der Schnittstelle zwischen der Leiterplatte und der wenigstens einen Akkuzelle, insbesondere den in Reihe geschalteten Akkuzellen, vorgesehen ist, um die Leiterplatte vor Kurzschlüssen und Überstrom zu schützen. Hierfür werden in der Regel elektrische Sicherungen als Zukaufteile verbaut, die ein leitfähiges Kernelement aufweisen, über das die gewünschte elektrische Verbindung geschaffen wird und das im unerwünschten Lastfall durchbrennt oder bricht, sowie ein dieses Kernelement umfassendes Gehäuse zum Schutz des Kernelements vor äußeren Einflüssen und zum Schutz der umgebenden Komponente im Falle eines Durchbrennens oder Durchbrechens des leitfähigen Kernelements vor eventuell abplatzenden Teilen. Nachteilig bei bekannten verwendeten elektrischen Sicherungen sind die vergleichsweise hohen Kosten der Zukaufteile.

Eine weitere in diesem Zusammenhang wichtige Komponente des Akkupacks ist die Ladestandsanzeige, die Akkupacks aufweisen können. Bei einer solchen kann der Anwender den aktuellen Ladezustand des Akkupacks prüfen. So ist beispielsweise eine Ladestandsanzeige in der DE 29515860 U1 beschrieben. Bei neueren Akkupacks ist eine solche Ladestandsanzeige direkt in das Akkupack integriert und zeigt beispielsweise durch unabhängig voneinander aktivierbare Leuchtelemente, ob das Ackupack voll geladen, teilweise geladen oder vollständig geladen ist. Auch kann ein Anwender beispielsweise durch Druck auf einen mechanischen Schalter den aktuellen Ladezustand abfragen, d.h. dass die Leuchtelemente als optische Indikatoren für Ladezustand des Akkupacks nur auf Anfrage hin für eine vorgegebene Zeitdauer aktiviert werden, um Strom zu sparen.

Für eine besonders einfache Umsetzung können die Leuchtelemente direkt auf der Leiterplatte vorgesehen sein und das Gehäuse Ausnehmungen aufweisen, durch die der Zustand der Leuchtelemente (aktiv, d.h. leuchtend, oder nicht) für den Anwender von außen sichtbar ist. Bei einer solchen Umsetzung können jedoch wiederum Luft und darin mitgeführte Partikel von außen über die Sichtausnehmungen in das Gehäuseinnere eindringen, was die bekannten Nachteile mit sich bringt.

Insbesondere die Montage der vielzähligen Komponenten eines Akkupacks ist in der Regel aufwändig und kostenintensiv. In der bekannten Praxis erfolgt die Verbindung der Leiterbleche mit der Leiterplatte, indem die Leiterbleche an die Leiterplatte gelötet werden.

Um sicherzustellen, dass umliegende Komponenten beim Lötprozess nicht beschädigt werden und um Kurzschlüsse mit stromleitenden Komponenten in unmittelbarer Nähe der Lotstelle zu vermeiden, musste in der Vergangenheit ein ausreichender Mindestabstand zwischen Lotstelle und stromleitenden Komponenten, wie beispielsweise der Minusstromsschiene, eingehalten werden. Dies führt zu einer Bauraumerhöhung der Akkupacks, was aus Anwendersicht nachteilig ist.

Ein weiterer Nachteil der bisher vorgesehenen Lötverbindung zwischen den Leiterblechen und Leiterplatte ist darin zu sehen, dass im Falle einer defekten Elektronik, das ganze Akkupack nicht mehr verwendet werden konnte.

Eine Aufgabe der vorliegenden Erfindung besteht daher darin, die aus dem Stand der Technik bekannt gewordenen Nachteile von Akkupacks zu verringern und ein verbessertes Akkupack bereitzustellen.

Als Lösung hierfür schlägt die vorliegende Erfindung ein Akkupack mit den Merkmalen des Anspruchs 1 sowie ein Elektrohandwerkzeuggerät mit den Merkmalen des Anspruchs 9 vor.

Demgemäß wird ein Akkupack, insbesondere für ein Elektrohandwerkzeuggerät, vorgeschlagen, mit wenigstens zwei in Reihe oder parallel geschalteten Akkuzellen und/oder Akkuzellenblöcken, einem Gehäuse mit einem Zellenträger zur Aufnahme der Akkuzellen und/oder Akkuzellenblöcke in übereinander angeordneten Reihen, und einer Leiterplatte, wobei die Akkuzellen im montierten Zustand des Akkupacks über Leiterbleche mit der Leiterplatte verbunden sind, und wobei wenigstens eines der Leiterbleche im montierten Zustand des Akkupacks mit der Leiterplatte zumindest abschnittsweise wenigstens zwei Leiterblechlagen umfasst.

Diese spezifische Ausgestaltung ermöglicht es in der Praxis, deutlich höhere Stromstärken über das wenigstens zweilagige Leiterblech zu führen, ohne das Risiko dieses infolge einer Überlast zu schädigen.

Der Zellenträger kann beispielsweise zweireihig aufgebaut sein, wobei jede Reihe wenigstens eine Akkuzelle, in der Regel jedoch mehrere Akkuzellen umfasst, die untereinander ebenfalls über Leiterbleche (Einzelzellenverbinder) miteinander verbunden sind. Diese Art von Leiterbleche kann nachfolgend auch als erste Leiterbleche bezeichnet sein, während die Leiterbleche zur Verbindung mit der Leiterplatte, insbesondere im Bereich des Bereich des Pluspols und des Minuspols, als zweite Leiterbleche bezeichnet sein können.

Jede Leiterblechlage kann insbesondere durch ein Leiterblech gebildet sein. Die Leiterblechlagen können miteinander verbunden sein (beispielsweise miteinander verschweißt sein) oder einfach überlappend zueinander oder nebeneinander angeordnet sein.

Gemäß einer Weiterbildung der Erfindung kann eine erste Leiterblechlage eine Ackuzelle einer ersten Reihe mit der Leiterplatte verbinden, und eine zweite Leiterblechlage kann eine Akkuzelle einer zweiten Reihe mit der Leiterplatte verbinden.

Insbesondere dann, wenn die Akkuzellen der ersten und zweiten Leiterblechlage direkt, d.h. ohne Versatz, in Spalten übereinander angeordnet sind, können sich die Leiterblechlagen eines zweiten Leiterblechs sich zumindest abschnittsweise überlappen.

Weiterhin kann vorgesehen sein, dass jede Leiterblechlage eines zweiten Leiterblechs jeweils mit einer zugeordneten Akkuzelle einer Reihe verschweißt ist.

Weiterhin können die Leiterblechlagen auch im Bereich der Verbindungsstelle mit der Leiterplatte überlappend angeordnet sein.

Dabei kann insbesondere vorgesehen sein, das wenigstens zweilagige (zweite) Leiterblech mittels einer Verbindungsschraube direkt oder indirekt mit der Leiterplatte verbunden ist.

So kann bei einer Ausführungsform, bei der die Akkuzellen in Reihe geschaltet sind, das wenigstens zweilagige (zweite) Leiterblech im Bereich des Minuspols bzw. des Pluspols mit der Leiterplatte verbunden sein.

Dabei kann das wenigstens zweilagige Leiterblech im Bereich des Minuspols insbesondere über eine Minusstromschiene indirekt mit der Leiterplatte verbunden sein und/oder das wenigstens zweilagige Leiterblech kann im Bereich des Pluspols insbesondere über ein elektrisch leitfähiges Sicherungselement indirekt mit der Leiterplatte verbunden sein.

Wie bereits vorstehend erwähnt können die Akkuzellen über wenigstens ein erstes Leiterblech miteinander verbunden sein. Zudem können die ersten und/oder zweiten Leiterbleche im montierten Zustand des Akkupacks mit der Leiterplatte über erste oder zweite Verbindungsschrauben verbunden sind.

Somit wird bei dieser Lösung eine zerstörungsfrei lösbare Verbindung zwischen den Leiterblechen und der Leiterplatte bereitgestellt, die es ermöglicht, im Falle einer defekten Elektronik, diese auszutauschen. Weiterhin kann durch die Nutzung von Verbindungsschrauben zur Herstellung einer Verbindung auch das Risiko eines Kurzschlusses, wie aus dem Stand der Technik bekannt, umgangen werden, selbst, wenn die Verbindungsstelle benachbart zu stromleitenden weiteren Komponenten des Ackupacks angeordnet ist. Insgesamt ist die Montage durch die Verwendung von Verbindungsschrauben vereinfacht.

Bei dem Akkupack kann es sich insbesondere um ein luftgekühltes Akkupack handeln, bei dem das Gehäuse Belüftungsausnehmungen aufweist, über die Kühlluft aus der Umgebung in das Gehäuseinnere eindringen und wieder an die Umgebung abgegeben werden kann.

Die Belüftungsausnehmungen im Gehäuse dienen dem Luftaustausch mit der Umgebung. Dabei kann die Umgebung sowohl die Außenluft sein als auch einen Kühlluftstrom umfassen, der von einem verbundenen Elektrowerkzeuggerät erzeugt und zumindest über einen Teil der Belüftungsausnehmungen in das Gehäuseinnere des Ackupacks eingeleitet wird. In gleicher Weise können die Belüftungsausnehmungen auch dann, wenn das Akkupack in einem korrespondierenden Ladegerät aufgenommen ist, zumindest teilweise als Lufteinlassöffnungen für einen von dem Ladegerät erzeugten Kühlluftstrom genutzt werden.

Weiterhin kann vorgesehen sein, dass die ersten Verbindungsschrauben zur Verbindung der ersten Leiterbleche mittels einer Kunststoffbeschichtung, beispielsweise aus Silikon, gegenüber der Umgebung abgedichtet sind.

Gemäß einer Ausführungsform der Erfindung kann das Gehäuse wenigstens einen von dem Rest des Gehäuses lösbaren Gehäuseteil, insbesondere einen Gehäusedeckel, umfassen, wobei der Gehäusedeckel an seiner Innenfläche mehrere domartige Vertiefungen zur Aufnahme der Schraubenköpfe der ersten Verbindungsschrauben aufweisen kann.

Dies ermöglicht zum einen eine raumsparende Konstruktion des Akkupacks und zugleich, gegebenenfalls in Verbindung mit einer vorstehend beschriebenen Kunststoffbeschichtung, eine besonders effiziente Abdichtung der Verbindungsstellen gegenüber Metallpartikeln und Fluidpartikeln, die mit der Kühlluft ins Innere des Akkupacks gelangen können.

Weiterhin kann vorgesehen sein, dass das Gehäuse einen Zellenträger zur Lagerung der Akkuzellen im Inneren des Gehäuses aufweist.

Dabei kann weiter vorgesehen sein, dass die innerhalb des Zellenträgers zueinander angeordneten Akkuzellen und/oder Akkuzellenblöcken im Wesentlichen parallel und im Bereich ihrer polseitigen Endabschnitte derart im Zellenträger angeordnet sind, dass sich die Pole der Akkuzellen nicht untereinander berühren.

Durch das Vorsehen mehrerer Akkuzellen, die in Reihe und/oder parallel zueinander geschaltet sein können, kann die Leistung, die das Akkupack abzugeben vermag, vergrößert und/oder die Leistungsabgabedauer verlängert werden. Die polseitigen Endabschnitte der im Wesentlichen parallel innerhalb des Zellenträgers angeordneten Ackuzellen bilden die beiden resultierenden Polbereiche des Akkupacks aus.

Nachfolgend wird zur Vereinfachung stets auf eine Ausführungsform eines Akkupacks mit mehreren Akkuzellen, beispielsweise mit zwei, drei, vier, sechs oder acht Akkuzellen, Bezug genommen. Selbstverständlich sind die in Zusammenhang damit beschriebenen Merkmale jedoch auch auf ein Akkupack mit einer Kombination von mehreren Akkuzellenblöcken oder mit einer Kombination von Akkuzellen mit Akkuzellenblöcken anwendbar.

Weiterhin kann der wenigstens eine lösbare Gehäuseteil, insbesondere der wenigstens eine Gehäusedeckel, lösbar mit dem Zellenträger verbindbar sein.

Für eine verbesserte Luftführung im Inneren des luftgekühlten Akkupacks kann im Inneren des Gehäuses eine Struktur zur Luftführung und Trennung der Polbereiche der Akkuzellen vorgesehen sein.

Indem die Luftführung im Inneren des Akkupackgehäuses entlang einer Trennlinie zur Trennung der Polbereiche der Akkuzellen verläuft, beispielsweise entlang einer Mittellängsachse des Akkupacks, kann eine aus der Praxis bekannt gewordene Brückenbildung durch angelagerte Metallpartikel signifikant erschwert und die Gefahr von auftretenden Kurzschlüssen weiter vermindert werden.

Die Akkuzellen können im Wesentlichen zylinderförmig ausgebildet sein, wobei der Begriff "zylinderförmig" nicht auf kreiszylinderförmige Querschnitte beschränkt ist, sondern im mathematischen Sinne durch eine wie auch immer geartete Grundfläche, die entlang einer vorgegebenen Kurve bewegt wird, gebildet wird. Gemäß der mathematischen Definition umfasst die zylindrische Form eine Mantelfläche sowie zwei Stirnflächen. Im Fall der Akkuzelle sind die Pole der Akkuzelle im Bereich der Stirnflächen angeordnet und bilden jeweils die resultierenden Polbereiche des Akkupacks aus.

Gemäß einer Weiterbildung kann dabei vorgesehen sein, dass das Akkupack einen Elektronikbecher aufweist, der wenigstens einen Teil der elektronischen Bauteile der Leiterplatte aufzunehmen vermag und insbesondere zur Luftführung und Trennung der Polbereiche der Akkuzellen beiträgt.

Insbesondere kann vorgesehen sein, dass der Elektronikbecher an einer von den aufgenommenen elektronischen Bauteilen abgewandten Oberfläche wenigstens ein luftleitendes Element, insbesondere ein Schott, zur Luftführung und Trennung der Polbereiche der Akkuzellen aufweist.

Weiterhin kann der Elektronikbecher aus Kunststoff hergestellt sein und insbesondere vergossen werden, um die darin aufgenommenen elektronischen Bauteile vor Verschmutzung zu schützen.

Unabhängig davon, ob das Akkupack einen Elektronikbecher umfasst, kann der von dem Rest des Gehäuses lösbare Gehäuseteil, insbesondere der Gehäusedeckel, an einer Innenfläche wenigstens ein luftleitendes Elemente, insbesondere ein Schott, zur Luftführung und Trennung der Polbereiche der Akkuzellen aufweisen.

Weiterhin kann der von dem Rest des Gehäuses lösbare Gehäuseteil, insbesondere zwei seitlich angeordnete Seitendeckel, wenigstens an seiner Innenseite ein eingespritztes Gummiteil zur verbesserten Abdichtung von im montierten Zustand anliegenden Komponenten des Akkupacks, insbesondere der Polbereiche, aufweisen.

Die Akkuzellen können derart im Zellenträger gelagert sein, dass sie im Bereich ihrer Mantelflächen zumindest abschnittsweise von der Kühlluft im Gehäuseinneren umströmt werden können. Weiterhin kann vorgesehen sein, dass die Akkuzellen im Bereich ihrer polseitigen Endabschnitte derart im Zellenträger gelagert sind, dass die resultierenden Polbereiche des Akkupacks luftdicht innerhalb des Gehäuses aufgenommen sind.

Eine Besonderheit dieser Ausführungsform der Erfindung liegt darin, dass die Akkuzellen nicht vollständig von der Kühlluft umströmt werden können, sondern nur im Bereich ihrer Mantelfläche. Die empfindlichen Pole der Akkuzellen und damit Polbereiche des Akkupacks, an denen eine Kurzschlussbildung und/oder Korrosion möglich sind, sind indes luftdicht innerhalb des Gehäuses aufgenommen, so dass weder Kühlluft noch darin enthaltene Partikel (Staub, Metall oder Wasser) aus der Umgebung oder Feuchtigkeit in Kontakt mit den Polen der jeweiligen Akkuzelle gelangen können. Auf diese Weise werden Kurzschlüsse im Bereich der Pole der Akkuzellen, wie sie in der Vergangenheit bei luftgekühlten Akkupacks auftreten konnten, und Korrosionsprobleme sicher und zuverlässig vermieden. Zugleich wird jedoch sichergestellt, dass dennoch ein Großteil der erzeugten Wärmeenergie an die Kühlluft im Inneren des Gehäuses abgegeben werden kann, wodurch das Risiko von Überhitzungen des Akkupacks verringert wird.

Es kann weiterhin vorgesehen sein, dass der lösbare Gehäuseteil, insbesondere der Gehäusedeckel, auf den Zellenträger aufgesetzt werden kann und beispielsweise die Belüftungsausnehmungen und/oder eine Struktur zur lösbaren Verbindung mit einem Elektrohandwerkzeuggerät und/oder Kontaktelemente zur elektrischen Verbindung mit einem Elektrohandwerkzeuggerät oder einem Akkuladegerät aufweist.

Es kann ferner vorgesehen sein, dass der Zellenträger geschlossene Seitenwände mit einer Anzahl von Lagerabschnitten zur Lagerung der polseitigen Endabschnitte der aufzunehmenden Akkuzellen aufweist, deren Innenumfang dem Außenumfang der aufzunehmenden Akkuzellen an ihren polseitigen Endabschnitten entspricht.

Definitionsgemäß sind die Pole im Bereiche der Stirnflächen der Akkuzellen angeordnet. Die polseitigen Endabschnitte umfassen jedoch nicht nur die Stirnflächen sondern auch einen angrenzenden Abschnitt der Mantelfläche der zugehörigen Akkuzelle, wobei gerade dieser Abschnitt der Mantelfläche im Übergangsbereich zu den Stirnflächen zur Lagerung der Akkuzellen genutzt wird. Diese polseitigen Endabschnitte der Ackuzellen haben eine spezifische Außenkontur und einen vorgegebenen Außenumfang. Die Lagerabschnitte sind dementsprechend so ausgebildet, dass deren Innenumfang dem Außenumfang der aufzunehmenden Akkuzellen an ihren polseitigen Endabschnitten entspricht. Die Akkuzellen können also mit einem möglichst geringen Spiel in die Lagerabschnitte der geschlossenen Seitenwände des Zellenträgers eingesetzt und auf diese Weise zuverlässig gelagert werden.

Es kann weiter vorgesehen sein, dass die Seitenwände des Zellenträgers geschlossen sind und nur im Bereich der Lagerabschnitte seitliche Ausnehmungen zur elektrischen Kontaktierung der Pole der Akkuzellen aufweisen. Alternativ zu dieser Ausgestaltung ist es grundsätzlich auch denkbar, dass die Lagerabschnitte selbst Mittel zur elektrischen Kontaktierung der Pole der Akkuzellen aufweisen. In dem Fall, in dem im Bereich der Lagerabschnitte seitliche Ausnehmungen zur elektrischen Kontaktierung der Pole der Akkuzellen vorgesehen sind, dienen die ansonsten geschlossenen Seitenwände des Zellenträgers zur Abgrenzung des luftdurchströmten Gehäuseinneren und dem luftdicht abgeschlossenen Gehäuseteil zur Aufnahme der Polbereiche des Akkupacks innerhalb des Gehäuses.

Aus der Praxis ist bekannt, dass die Akkuzellen, beispielsweise wenn sie als Lithiumionenakkuzellen ausgebildet sind, bei Überhitzung über ein Ventil am Plus-Pol große Mengen an Gas ausstoßen. Demgemäß besteht das Risiko, dass ein komplett abgedichteter Polbereich eines Akkupacks beim Abgasen einer oder mehrerer Zellen zu einer Beschädigung des Akkupacks führen könnte. Um auch diesem möglichen Problem zu begegnen, kann vorgesehen sein, dass der Zellenträger wenigstens eine Druckausgleichsvorrichtung aufweist, die im Falle eines vorbestimmten Überdrucks an einem der Polbereiche des Akkupacks einen Druckausgleich, insbesondere mit dem Gehäuseinneren und über die Belüftungsausnehmungen des Gehäuses mit der Umgebung, ermöglicht.

Weiterhin kann vorgesehen sein, dass eine solche Druckausgleichsvorrichtung in dem Fall, in dem die Seitenwände des Zellenträgers geschlossen ausgebildet sind und zur Abgrenzung des Gehäuseinneren von den luftdicht umschlossenen Polbereichen dienen soll, an jeder der Seitenwände des Zellenträgers ausgebildet ist.

Ferner kann vorgesehen sein, dass die Druckausgleichsvorrichtung eine Sollbruchstelle, eine Ausnehmung, die mit einer Membran, einem Dichtungsteil oder dergleichen abgedeckt ist, oder ein Ventil umfasst. So stellt beispielsweise eine vorgegebene Sollbruchstelle eine einfach herzustellende und kostengünstige Lösung für eine Druckausgleichsvorrichtung dar, während eine abgedeckte Ausnehmung im Falle einer Zerstörung der Abdeckung (sei es eine Membran, ein Dichtungsteil oder dergleichen) zumindest reparierbar, aber etwas teurer in der Herstellung ist. Schließlich stellt ein Ventil eine Lösung dar, die über die gesamte Lebensdauer des Akkupacks immer wieder zum Einsatz kommen kann; jedoch ist ein solches Ventil in der Herstellungsmontage vergleichsweise kostenintensiv.

Gemäß einer Weiterbildung der Erfindung kann zudem vorgesehen sein, dass die Leiterplatte eine Ladestandsanzeige aufweist, wobei die Ladestandsanzeige mit Hilfe von aktivierbaren Leuchtelementen, insbesondere LEDs, eine Information über den Ladestand des Akkupacks sichtbar machen kann, und wobei das Gehäuse Ausnehmungen aufweist, durch die der Zustand der aktivierbaren Leuchtelemente erkennbar ist. Bei dieser Variante kann zwischen dem Gehäuse und der Leiterplatte im Bereich der Ladestandsanzeige ein elastisches Dichtelement vorgesehen ist, das das Gehäuse im Bereich der Ladestandsanzeige gegenüber der Umgebung zuverlässig abzudichten vermag. Hierdurch wird wiederum ein verbesserter Staubschutz und Schutz vor Flüssigkeitspartikeln (und damit Korrosion im Inneren des Akkupacks) geschaffen.

Zusätzlich kann vorgesehen sein, dass die Leiterplatte wenigstens einen mechanischen Schalter zum Aktivieren der Ladestandsanzeige umfasst, der durch eine Ausnehmung das Gehäuse des Akkupacks zur manuellen Betätigung durch einen Anwender durchragt, und wobei das elastische Dichtelement insbesondere einen Schalterdom umfasst, der den mechanischen Schalter aufzunehmen vermag, um das Gehäuse im Bereich des mechanischen Schalters gegenüber der Umgebung zuverlässig abzudichten.

Das elastische Dichtelement kann bei dieser Ausführungsform somit sowohl den mechanischen Schalter als auch die Ausnehmungen für die Leuchtelemente gegenüber der Umgebung abdichten, was besonders vorteilhaft ist.

Weiterhin kann das elastische Dichtelement aus Gummi, Silikon oder dergleichen ausgebildet sein. In einer denkbaren Ausführungsform kann das Dichtelement insbesondere aus einem durchsichtigen Material geformt sein, wodurch ein Durchscheinen der von den Leuchtelementen emittierten Lichtstrahlen nach außen ermöglicht wird.

Alternativ oder zusätzlich kann für eine verbesserte Sichtbarkeit der emittierten Lichtstrahlen der Leuchtelemente das elastische Dichtelement Ausnehmungen aufweisen, durch die der Zustand der aktivierbaren Leuchtelemente erkennbar ist.

Weiterhin kann vorgesehen sein, dass der von dem Rest des Gehäuses lösbare Gehäuseteil, insbesondere der Gehäusedeckel, zumindest abschnittsweise das elastische Dichtelement gegen die Leiterplatte vorzuspannen vermag. Hierdurch wird auf besonders einfache Weise eine definierte Lage des elastischen Dichtelements im montierten Akkupack sichergestellt.

Dabei kann vorgesehen sein, dass der von dem Rest des Gehäuses lösbare Gehäuseteil, insbesondere der Gehäusedeckel, wenigstens eine im montierten Zustand innere Gehäusewand aufweist, die in Richtung zu der Leiterplatte vorsteht und zumindest abschnittsweise das elastische Dichtelement gegen die Leiterplatte vorzuspannen vermag.

Zudem kann das elastische Dichtelement Ausnehmungen zur definierten Anlage an der Leiterplatte aufweisen. Durch diese Maßnahme wird wiederum die Montage erleichtert und sichergestellt, dass das elastische Dichtelement bis zur fertiggestellten Montage des Akkupacks nicht gegenüber der Leiterplatte verrutscht.

Wie vorstehend erwähnt kann außerdem vorgesehen sein, dass die Leiterplatte mit den Akkuzellen indirekt über wenigstens ein elektrisch leitfähiges Sicherungselement elektrisch verbindbar ist. Das Gehäuse kann dabei einen Sicherungsbereich aufweisen, der zur sichernden Aufnahme der wenigstens einen elektrisch leitfähigen Sicherungselements dient und integral mit dem Gehäuse ausgebildet ist, wobei der Sicherungsbereich im montierten Zustand des Akkupacks das elektrisch leitfähige Sicherungselement zumindest abschnittsweise einzuhausen vermag.

Eine Besonderheit dieser Ausführungsform der Erfindung liegt somit darin, dass nicht eine elektrische Sicherung als separates von den übrigen Komponenten des Akkupacks losgelöstes Bauteil, insbesondere in der Form eines Zukaufteils, eingesetzt wird, sondern zumindest das Gehäuse der elektrischen Sicherung durch einen integral mit dem Gehäuse des Akkupacks ausgebildeten Sicherungsbereich gebildet wird. Der Sicherungsbereich dient dabei gleich dem Gehäuse bei elektrischen Sicherungen zum Schutz des elektrisch leitfähigen Sicherungselements vor äußeren Einflüssen und zum Schutz der umgebenden Komponente im Falle eines Durchbrennens oder Durchbrechens des leitfähigen Sicherungselements vor eventuell abplatzenden Teilen.

So kann das elektrisch leitfähige Sicherungselement vollständig im Sicherungsbereich aufgenommen und eingehaust sein, um mögliche Anlagerung von Metallpartikeln oder Wasserpartikeln in der Kühlluft an dem Sicherungselement und die damit verbundenen Nachteile zu vermeiden. Zudem können die umliegenden elektronischen Komponenten des Akkupacks vor etwaigen abplatzenden Teilen des Sicherungselements geschützt werden, wenn dieses durchschmilzt oder durchbricht.

Üblicherweise kann das Gehäuse aus einem Kunststoffmaterial urgeformt, insbesondere gegossen werden, so dass eine integrale Ausbildung des Sicherungsbereichs als Gehäuse für das Sicherungselement besonders kostengünstig umgesetzt werden kann. Das leitfähige Sicherungselement wiederum kann ebenfalls sehr einfach durch einen elektrisch leitfähigen Draht oder ein Blechteil verwirklicht sein, so dass insgesamt eine gegenüber dem Stand der Technik deutlich kostengünstigere Lösung für eine elektrische Sicherung bereitgestellt werden kann.

Es kann ferner vorgesehen sein, dass der Sicherungsbereich zumindest abschnittsweise an dem lösbaren Gehäuseteil ausgebildet ist und wenigstens eine (vorzugsweise zwei) im montierten Zustand innere Gehäusewand aufweist, die das im Sicherungsbereich aufgenommene elektrisch leitfähige Sicherungselement von den benachbarten elektrischen Bauteilen abzutrennen vermag.

Bei dieser Ausführungsform der Erfindung ist vorteilhaft, dass durch die teilweise Ausbildung des Sicherungsbereich an einem vom dem Rest des Gehäuses lösbaren Gehäuseteil, wie beispielsweise dem Gehäusedeckel, eine erleichterte Zugänglichkeit der Sicherungselements im Fall eines notwendigen Austauschs des Sicherungselements erreicht wird. Dabei umfasst der Sicherungsbereich wenigstens eine von dem Gehäuseteil nach innen in das Gehäuseinnere ragende Gehäusewand, die zur Einhausung des Sicherungselements oder Abtrennung des Sicherungselements von den benachbarten elektrischen Bauteilen dient.

Dabei bleibt das eingehauste bzw. abgetrennte Sicherungselement dennoch zum Erfüllen seiner Funktion elektrisch mit der Leiterplatte und dem zweiten Leiterblechverbunden.

Selbstverständlich kann der Sicherungsbereich alternativ oder zusätzlich zumindest abschnittsweise an dem Zellenträger zur Lagerung der Akkuzellen im Inneren des Gehäuses ausgebildet sein und wenigsten eine im montierten Zustand innere Gehäusewand aufweisen, die das im Sicherungsbereich aufgenommene elektrisch leitfähige Sicherungselement von den benachbarten elektrischen Bauteilen abzutrennen vermag.

Es kann unabhängig von der konkreten Vorsehung und Ausgestaltung eines Sicherungsbereichs am lösbaren Gehäuseteil und/oder am Zellenträger zudem vorgesehen sein, dass wenigstens eine zwischen dem lösbaren Gehäuseteil und dem Rest des Gehäuses vorgesehene Dichtung vorgesehen ist.

In einer denkbaren Ausgestaltungsvariante sind, wie vorstehend bereits erwähnt, zwei Seitendeckel vorgesehen, die jeweils im Bereich der Pole bzw. Stirnflächen der aufgenommenen Akkuzellen angeordnet sind und lösbar mit dem die Akkuzellen aufnehmenden Zellenträger verbindbar sind. Bei dieser Lösung wird das Gehäuse zur Aufnahme der Akkuzellen im Wesentlichen durch den Zellenträger und die beiden seitlichen Deckel gebildet.

Der zusätzliche Gehäusedeckel als lösbares Gehäuseteil kann auf den Zellenträger aufgesetzt werden, wie bereits vorstehend ausgeführt, und kann beispielsweise die Belüftungsausnehmungen und/oder eine Struktur zur lösbaren Verbindung mit einem Elektrohandwerkzeuggerät und/oder Kontaktelemente zur elektrischen Verbindung mit einem Elektrohandwerkzeuggerät oder einem Akkuladegerät und/oder die Ausnehmungen aufweisen, durch die der Zustand der aktivierbaren Leuchtelemente erkennbar ist und/oder durch die der mechanische Schalter sich erstrecken kann.

Es kann weiter vorgesehen sein, dass die Dichtung als umlaufende Dichtung an dem einem oder an mehreren (im Falle von mehreren) lösbaren Gehäuseteil(en) vorgesehen ist.

Weiterhin kann die Dichtung eine Nut-Feder-Geometrie und/oder eine Elastomerdichtung umfassen. So kann beispielsweise vorgesehen sein, dass eine umlaufende Nut-Feder-Geometrie am Zellenträger und an dem oder den seitlichen Deckeln ausgestaltet ist, die den zugehörigen Polbereich des Akkupacks vom Gehäuseinneren dicht abschließt. Eine solche Dichtung kann alternativ jedoch auch als eine eingelegte oder eingespritzte Dichtung aus einem elastischen Material wie Moosgummi, Filz, Kunststoff oder dergleichen ausgebildet sein.

Daneben wird ein Elektrohandwerkzeuggerät mit einem Elektromotor sowie wenigstens einem hiermit lösbar verbindbaren Akkupack mit den vorstehenden Merkmalen vorgeschlagen, wobei wenigstens eine Schnittstelle zur mechanischen und elektrischen Verbindung des Akkupacks mit dem Elektrohandwerkzeuggerät vorgesehen ist.

Schließlich wird auch ein Verfahren zur Herstellung eines Akkupacks mit den vorstehenden Merkmalen vorgeschlagen, das die Schritte umfasst: Einsetzen der Akkuzellen und/oder Akkuzellenblöcke in den Zellenträger des Gehäuses des Akkupacks; Verbinden der Akkuzellen mit ersten oder zweiten Leiterblechen, wobei wenigstens eines der zweiten Leiterbleche im montierten Zustand des Akkupacks mit der Leiterplatte zumindest abschnittsweise wenigstens zwei Leiterblechlagen umfasst.; Einsetzen der Leiterplatte in das Gehäuse des Akkupacks; Verbinden der ersten und zweiten Leiterbleche mittels ersten und zweiten Verbindungsschrauben mit der Leiterplatte.

Dabei kann der Schritt Einsetzen der Akkuzellen in das Gehäuse die Schritte Einsetzen der Akkuzellen in den Zellenträger; und Verbinden von wenigstens einem lösbaren Gehäuseteil, insbesondere von zwei Seitendeckeln und einem Gehäusedeckel, mit dem Zellenträger umfassen. Diese besondere Ausführungsform stellt auf ein Akkupack mit einem Gehäuse ab, das sich zumindest aus den Bauteilen Zellenträger, Seitendeckel und Gehäusedeckel zusammensetzt. Diese Lösung hat den Vorteil, dass das Einsetzen der Akkuzellen und das Einsetzen und Montieren der weiteren Komponenten, wie Leiterplatte und Leiterbleche durch eine verbesserte Zugänglichkeit deutlich vereinfacht wird. Erst wenn alle im Gehäuse innenliegenden Komponenten montiert sind, wird abschließend das Gehäuse durch das Verbinden der lösbaren Gehäuseteile mit dem Zellenträger vorgenommen. Der Zellenträger bildet dabei die Kernstruktur des Akkupacks aus.

Dabei erfolgt zeitlich nach, aber nicht unmittelbar nach dem Schritt Verbinden der ersten und zweiten Leiterbleche mittels ersten und zweiten Verbindungsschrauben mit der Leiterplatte der Schritt Verbinden von wenigstens einem lösbaren Gehäuseteil, insbesondere von zwei Seitendeckeln und einem Gehäusedeckel, mit dem Zellenträger.

Weitere Merkmale der Erfindung sind in der nachfolgenden Figurenbeschreibung und den Ansprüchen erläutert.

Die Figurenbeschreibung beschreibt eine mögliche Ausführungsform der vorliegenden Erfindung im Detail, wobei auch unabhängige Merkmale der Erfindung in Kombination miteinander dargestellt sind. Selbstverständlich kann ein Fachmann diese jedoch auch losgelöst voneinander betrachten und diese zu weiteren sinnvollen Unterkombinationen zusammenfügen, ohne hierfür erfinderisch tätig werden zu müssen.

Die Figuren zeigen schematisch:
- Figur 1: eine isometrische Ansicht eines bestückten Zellenträgers eines erfindungsgemäßen Akkupacks mit Seitenteilen in Explosionsdarstellung;
- Figur 2: ein als Seitendeckel des Zellenträgers gemäß Figur 1 ausgebildetes lösbares Gehäuseteil;
- Figur 3: einen teilbestückten Zellenträger gemäß Figur 1 in isometrischer Darstellung;
- Figur 4: ein erfindungsgemäßes Akkupack in längsgeschnittener Darstellung;
- Figur 5A: eine Schnittansicht gemäß der Schnittlinie A-A der Figur 4 des erfindungsgemäßen Akkupacks;
- Figur 5B: eine Schnittansicht entlang der Schnittlinie B-B der Figur 4 des erfindungsgemäßen Akkupacks;
- Figur 6: einen Gehäusedeckel für den Zellenträger und die Seitenteile gemäß Figur 1 in isometrischer Darstellung;
- Figur 7: eine um 90° gedrehte Querschnittsansicht entlang der Schnittlinie A-A der Figur 1 des Zellenträgers mit montierten Seitenteilen;
- Figur 8A: eine Detailansicht des erfindungsgemäßen Akkupacks gemäß dem Detail A in der Figur 7;
- Figur 8B: eine Detailansicht des erfindungsgemäßen Akkupacks gemäß dem Detail B in der Figur 7; und
- Figur 9: eine Detailansicht des erfindungsgemäßen Akkupacks gemäß dem Detail C in der Figur 4.

Die Figuren zeigen eine erfindungsgemäße Ausführungsform eines Akkupacks für ein Elektrohandwerkzeuggerät, das allgemein mit dem Bezugszeichen 10 bezeichnet ist.

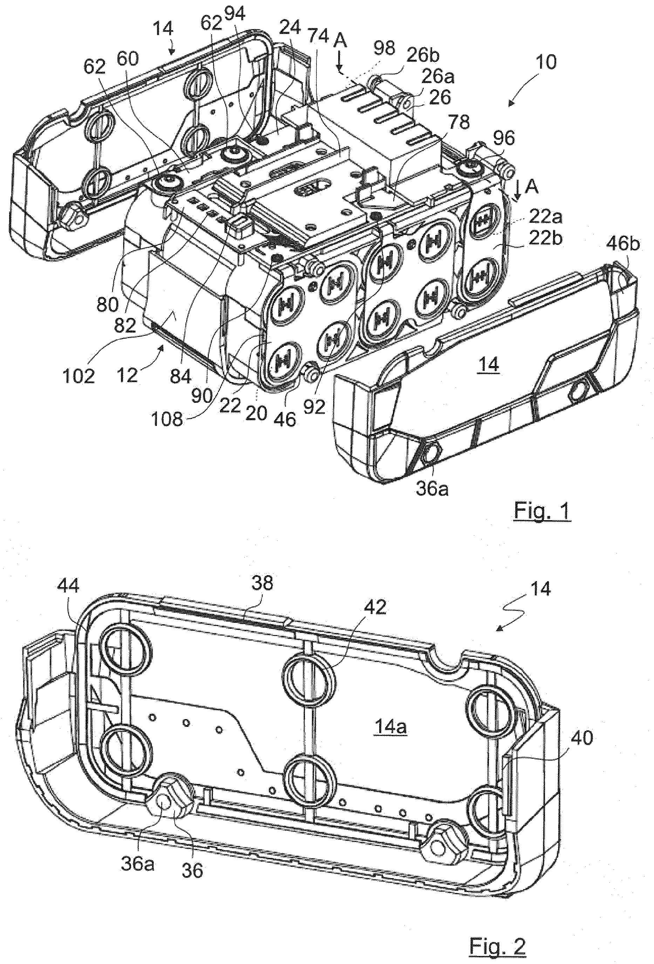

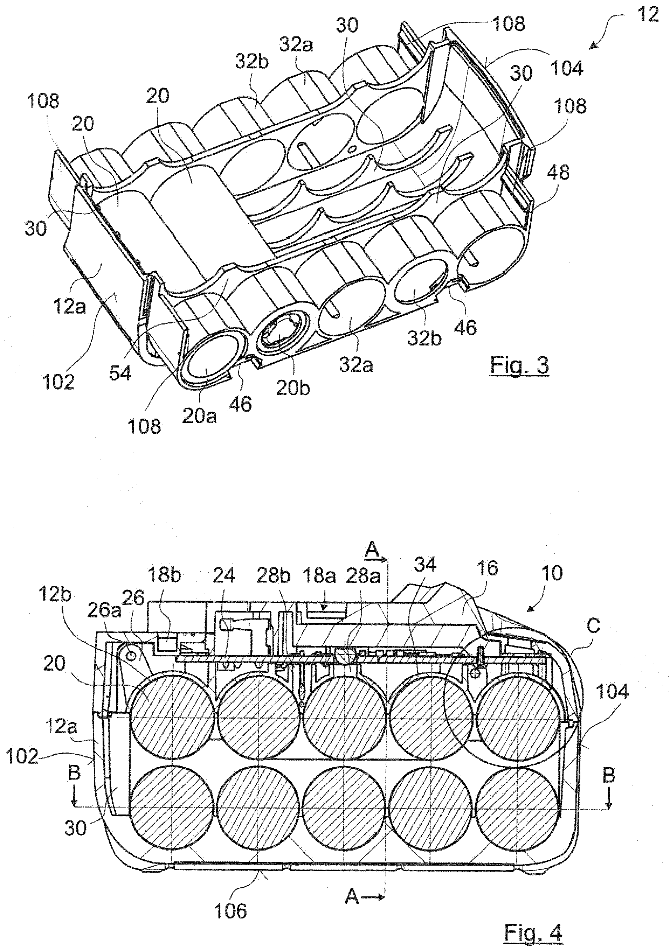

Das Gehäuse eines erfindungsgemäßen Akkupacks 10 setzt sich aus mehreren das Gehäuse bildenden Gehäuseteilen wie folgt zusammen: einem Zellenträger 12, zwei Seitendeckel 14 (vgl. auch Figur 2), die seitlich an dem Zellenträger 12 lösbar angebracht werden, sowie wenigstens einem Gehäusedeckel 16 (vgl. Figur 4), der auf den Zellenträger 12 lösbar aufgesetzt werden kann. In der Figur 1 sind dabei die beiden Seitendeckel 14 als lösbare Gehäuseteile zur besseren Darstellung der innenliegenden Komponenten des Akkupacks 10 nicht an dem Zellenträger 12 angebracht.

Eine Besonderheit gegenüber dem Stand der Technik ist darin zu sehen, dass der Zellenträger 12 mit seinen äußeren Oberflächen 102, 104 und 106 (vgl. Figuren 1, 3, 4 und 5A) zugleich einen Teil der Gehäuseaußenfläche bildet. Hierdurch wird zum einen die Wärmeabgabe des Akkupacks 10 nach außen verbessert und zum anderen der Kostenaufwand, Montageaufwand und das Gewicht des Akkupacks 10 gegenüber den bekannten Lösungen verringert.

Der Zellenträger 12 ist in der gezeigten Ausführungsform zudem zweiteilig aufgebaut und umfasst einen in den Figuren 1, 3, 4, 5A unteren Trägerteil12a, der zur Aufnahme einer ersten unteren Reihe von (in der dargestellten Ausführungsform sind es fünf) Akkuzellen 20 ausgebildet ist, und einen oberen Trägerteil 12b, der zur Aufnahme einer zweiten oberen Reihe von (in der dargestellten Ausführungsform sind es fünf) Ackuzellen 20 ausgebildet ist. Die beiden Trägerteile 12a, 12b sind formschlüssig über eine Rastverbindung 108 (wie in der Figur 1 angedeutet und in der Figur 3 als Rastnase 108 am unteren Trägerteil 12a gezeigt) miteinander verbunden.

Der Gehäusedeckel 16 ist insbesondere in den Figuren 4, 5A und 6 gezeigt und umfasst mehrere Belüftungsausnehmungen 18a und 18b, über die Kühlluft aus der Umgebung des Akkupacks 10 in das Gehäuseinnere eindringen und wieder an die Umgebung abgegeben werden kann. Bei dem vorliegenden Akkupack 10 handelt es sich somit um ein sogenanntes luftgekühltes Akkupack, bei dem die im Gehäuseinneren aufgenommenen Akkuzellen 20 zumindest im Bereich ihrer Mantelfläche von der Kühlluft umströmt werden können.

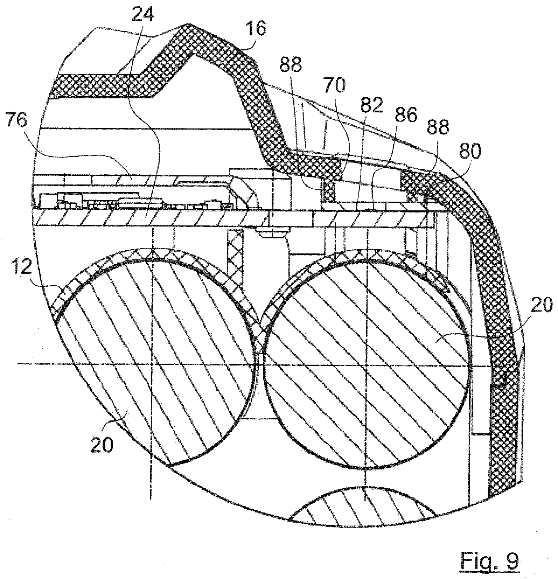

In der dargestellten Ausführungsform umfasst das erfindungsgemäße Akkupack 10 zehn Akkuzellen 20, die im Wesentlichen parallel zueinander angeordnet sind. Die Ackuzellen 20 werden über Leiterbleche 22 im Bereich ihrer einzelnen Pole 20a und 20b (vgl. Figur 3) elektrisch kontaktiert, wobei die Leiterbleche 22 wiederum elektrisch mit einer Leiterplatte 24 verbunden sind. Die Leiterplatte 24 kann mit einer Reihe von Elektronikkomponenten, wie beispielsweise einen Schalter oder LEDs 86 (vgl. Figur 9) bestückt sein, auf die nachfolgend nicht näher eingegangen werden soll. Wie in der Figur 1 deutlich zu erkennen ist, ist die Leiterplatte 24 über erste Verbindungsschrauben 90, 92,94, 98 lösbar mit dem Zellenträger 12 verbunden.

Anders als im Stand der Technik sind bei der gezeigten Ausgestaltungsvariante eines Akkupacks 10 die Leiterbleche 22 zur Einzelzellenverbindung über erste Schraubverbindungen 90, 92, 94, 98 an Leiterplatte 24 und Zellenträger 12 angebracht. Gleiches gilt für die Verbindung des Leiterblechs 22 mit einer Minusstromschiene 78 an der Leiterplatte 24 und der Leiterblechs 22 mit einer elektrischen Sicherung, die ebenfalls über zweite Schraubverbindungen 96 und 62 erfolgen (vgl. Figur 1), während sie im Stand der Technik in der Regel gelötet wurden.

Der Vorteil gegenüber einer Lötverbindung besteht darin, dass das Risiko eines Kurzschlusses, insbesondere bei geringen Abständen der Verbindungsstelle beispielsweise zu einer Stromschiene (vgl. Verbindungsschraube 92 benachbart zu Minusstromschiene 78), umgangen werden kann. Weiterhin ist die Montage gegenüber dem Stand der Technik vereinfacht und ein Austausch der Elektronik bei einem festgestellten Defekt möglich, da Schraubverbindungen im Unterschied zu stoffschlüssigen Verbindungen wie Löten, zerstörungsfrei lösbar sind.

Die ersten Verbindungsschrauben 90, 92, 94, 98, insbesondere ihre Kopfabschnitte können in korrespondierende Vertiefungen 100 am Gehäusedeckel 16 aufgenommen sein und zusätzlich mit Silikon abgedichtet werden.

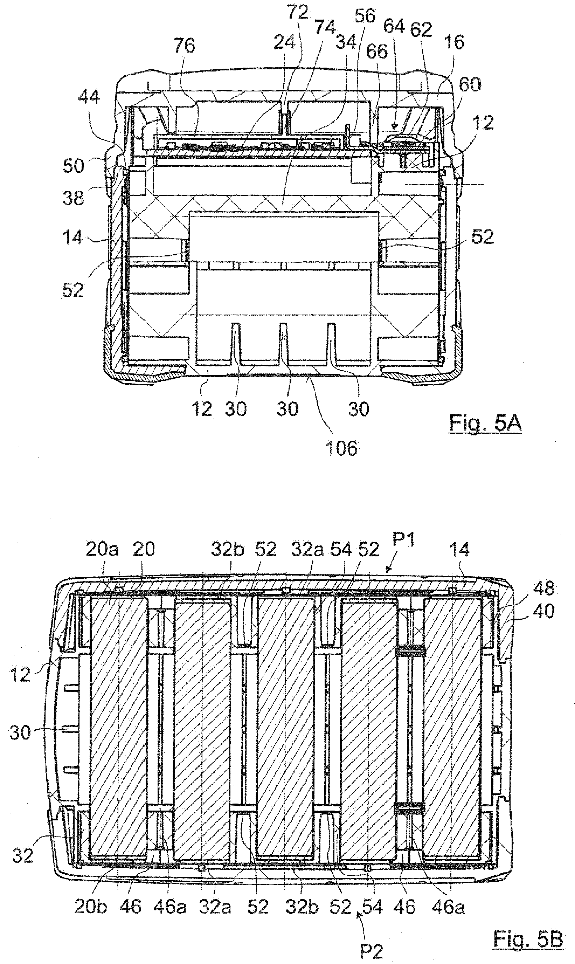

Zur Befestigung des Gehäusedeckels 16 weist der Zellenträger 12 zudem Befestigungsvorsprünge 26 mit Gewindeausnehmungen 26a auf, in die entsprechend Befestigungsschrauben 26b (vgl. Figur 1) zur Befestigung des Gehäusedeckels 16 eingeschraubt werden können. Weiterhin umfasst der erfindungsgemäße Zellenträger 12 auf seiner der Leiterplatte zugewandten Oberseite 34 (Figuren 4 und 5A) Ausnehmungen 28a und 28b auf, die beispielsweise zur Einführung eines Temperaturfühlers oder dergleichen ausgehend von der Leiterplatte 24 genutzt werden können.

Um eine möglichst effiziente Umströmung der aufgenommenen Akkuzellen 20 im Gehäuseinneren, das heißt insbesondere im Inneren des Zellenhalters 12, zu gewährleisten, weist dieser Lüftungsrippen 30 auf (vgl. Figur 3), die sowohl zur Abstützung der unteren Reihe der aufgenommenen Akkuzellen dienen, als auch eine geführte Luftführung durch den Zellenträger 12 ermöglichen. Eine besonders effiziente Umströmung der Akkuzellen 20 im Bereich ihrer Mantelflächen im Inneren des Zellenträgers 12 kann auch dadurch erreicht werden, dass auch die obere Reihe der aufgenommenen Akkuzellen nicht vollständig im Bereich ihrer Mantelflächen von dem Zellenträger 12 umgeben sind, sondern nur teilflächig im Bereich der Oberseite 34 des Zellenträgers 12 (vgl. Figur 4). Der Abschnitt der Mantelflächen der aufgenommenen Akkuzellen, der der darunterliegenden Reihe von Akkuzellen gegenüber liegt, ist indes vollkommen frei und ungestützt, sodass in diesem Bereich die Kühlluft ungehindert zirkulieren kann.

Damit die aufgenommenen Akkuzellen 20 nicht nur in der gewünschten Weise parallel zueinander angeordnet, sondern auch in Abstand zueinander gehalten werden können, um auf diese Weise Kurzschlüsse zu vermeiden (vgl. Figuren 4 und 5B) weist der Zellenträger Lagerabschnitte 32a und 32b auf, die zur Lagerung der Akkuzellen 20 im Bereich ihrer polseitigen Endabschnitte vorgesehen sind. Die Lagerabschnitte 32a und 32b sind dabei derart dimensioniert, dass die Akkuzellen fest in dem Zellenträger 12 gelagert und nahezu spielfrei darin aufgenommen sind. Weiterhin ist ein Lagerabschnitt 32a für eine Akkuzelle seitlich geöffnet, um ein Einschieben der Akkuzelle zu ermöglichen, während der korrespondiere andere Lagerabschnitt 32b eine Lagerschulter zur axialen Lagerung (bezüglich der Längsachse der aufgenommenen Akkuzelle) aufweist. Zu der elektrischen Kontaktierung ist selbstverständlich zusätzlich eine zentrale Ausnehmung im Bereich des Lagerabschnitts 32b vorgesehen (vgl. Figuren 3 und 5B).

Wie bereits erwähnt, sind auch die Seitendeckel 14 des Gehäuses des Akkupacks 10 als lösbare Gehäuseteile ausgebildet. In den Figuren 1 und 2 ist besonders gut erkennbar, dass der Seitendeckel 14 Befestigungsfortsätze 36 aufweist, die Bohrungen 36a zur Aufnahme einer Schraube umfassen. Die Schrauben 46b (vgl. Figur 1) können durch die Bohrungen 36a des Befestigungsfortsatzes 36 in korrespondierende Gewindebohrungen 46a im Bereich der Befestigungsabschnitte 46 des Zellenträgers 12 eingeschraubt werden.

Weiterhin weist der Seitendeckel 14 gemäß Figur 2 eine obere Haltekante 38 auf, die im montierten Zustand des Akkupacks 10 von einer korrespondierenden Haltekante 50 des Gehäusedeckels 16 übergriffen werden kann (vgl. Figur 5A) sowie eine Haltekante 40, die ihrerseits eine korrespondierende Haltekante 48 (vgl, Figur 3 und Figur 5B) des Zellenträgers 12 im montierten Zustand des Akkupacks 10 zu übergreifen vermag.

Auf der Innenseite der Seitendeckel 14 können zusätzlich in die Deckel eingespritzte Gummiteile 14a zur dichtenden Aufnahme der Polbereiche und Lagerfortsätze 42 vorgesehen sein, die der lagernden Klemmung der Leiterbleche 22 dienen können.

Um weiter eine Abdichtung des Akkupacks im Bereich der resultierenden Polbereiche P1 und P2 (vgl. Fig. 5B) des Akkupacks 10 zu erreichen, ist bei dem dargestellten Ausführungsbeispiel zudem jeweils eine umlaufende Dichtung 44 vorgesehen, die im montierten Zustand des zugehörigen Seitendeckels 14 am Zellenhalter 12 den resultierenden Polbereiche P1 bzw. P2 des Akkupacks 10 luftdicht gegenüber der Umgebung abzudichten vermag. Diese Dichtung 44 kann beispielsweise als Elastomerdichtung oder als Nutfedergeometrie ausgebildet sein.

Aus einer Zusammenschau der Figuren 5A und 5B ergibt sich zudem, dass der Zellenträger 12 über (mit Ausnahme der Lagerabschnitte 32a und 32b mit ihren seitlichen Ausnehmungen) luftdicht geschlossene Seitenwände 54 verfügt, die eine nahezu luftdichte Abdichtung der Polbereiche P1 und P2 des Akkupacks 10 gegenüber dem luftdurchströmten Gehäuseinneren ermöglicht. Indem die Akkuzellen 20 nahezu spielfrei in den Lagerabschnitten 32a und 32b aufgenommen sind, kann über die seitlichen Ausnehmungen der Lagerabschnitte 32a, 32b kein Luftaustausch zwischen dem Gehäuseinneren und den Polbereichen P1 und P2 erfolgen. Zudem sind auch in den Gewindebohrungen 46a im montierten Zustand des Akkupacks 10 Befestigungsschrauben aufgenommen, die einen Luftaustausch hierüber verhindern.

Um jedoch sicherzustellen, dass ein Ausgasen der Akkuzellen im Falle einer Überhitzung einer oder mehrerer Akkuzellen im Inneren des Akkupacks 10 möglich bleibt (und um so potentielle Explosionen zu vermeiden) sind im dargestellten Ausführungsbeispiel im Bereich der Seitenwände 54 Sollbruchstellen 52 vorgesehen, deren verminderte Wandstärke im Falle eines Überdrucks in einem der Polbereiche P1 oder P2 ein Durchbrechen der Seitenwand 54 ermöglicht und damit einen Luftaustausch in das Gehäuseinnere. Über die ohnehin vorgesehenen Belüftungsöffnungen 18a und 18b des Gehäuses kann dann ein Ausgasen problemlos erfolgen.

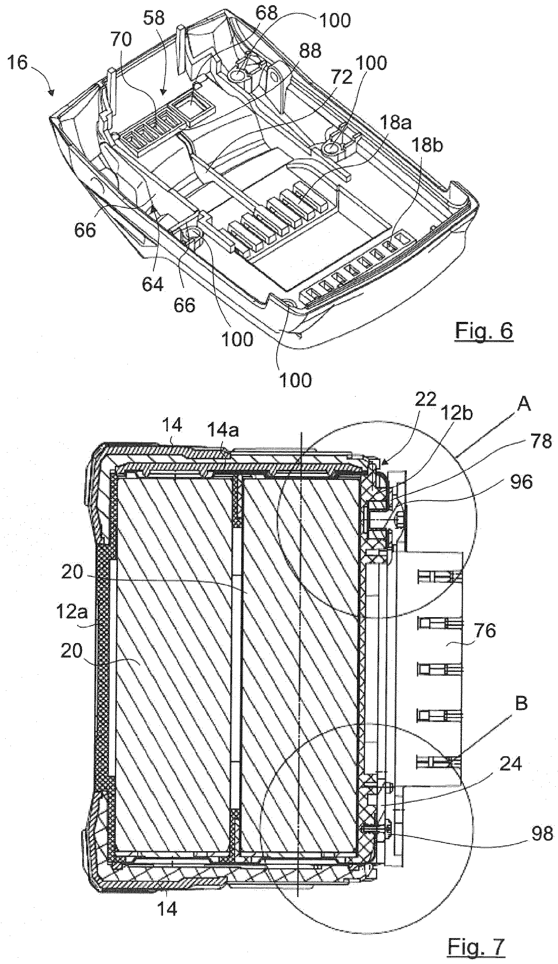

Eine weitere vorteilhafte Ausgestaltungsvariante zur Vermeidung von anhaftenden Metallpartikeln im Bereich der Pole P1 und P2 und insbesondere zur Vermeidung von Brückenbildung und Kurzschluss durch anhaftende Metallpartikel wird durch die Ausbildung einer Trennung von Plus- und Minusbereich im Inneren des Akkupacks 10 erreicht. Hierzu weist der Gehäusedeckel 16 im Inneren ein Schott 72 auf, das mit einem korrespondierenden Schott 74 an einem Elektronikbecher 76 des Akkupacks 10 (vgl. Figuren 5A und 6) oder einem anderen Bauteil im Inneren des Akkupacks 10 zusammenwirkt und gemeinsam eine Trennwand im Inneren des Akkupacks 10 ausbildet.

Der Elektronikbecher 76 kann insbesondere vergossen werden und zum Schutz der elektronischen Bauteile vor Verschmutzung und Korrosion auf diesen vorgesehen sein.

Eine weitere Maßnahme zur Verbesserung des Staubschutzes im Inneren des luftgekühlten Akkupacks 10 ist in dem Vorsehen eines separat ausgebildeten elastischen Dichtelements, dem Gummiformteil 80, im Bereich einer Ladestandsanzeige des Ackupacks 10 zu erkennen.

Übliche Ladestandsanzeigen weisen einen an der Leiterplatte angebrachten Schalter auf, der dann, wenn er von einem Anwender gedrückt wurde, ein Signal an die Leiterplatte weitergibt, so dass auf der Leiterplatte angebrachte LEDs in Abhängigkeit von dem aktuellen Ladezustand für eine vorgegebene Zeitdauer beleuchtet werden oder nicht. An dem Gehäuse, beispielsweise dem Gehäusedeckel 16 sind entsprechend Ausnehmungen 68 für den Schalter und für die Anzeige 70 der LEDs vorgesehen, durch die die LEDs sich erstrecken oder durch die zumindest deren Beleuchtungszustand sichtbar ist. Werden alle LEDs aktiviert, ist das Akkupack vollgeladen, mit abnehmender Anzahl an aktivierten LEDs erkennt der Benutzer einen abnehmenden Ladezustand des Akkupacks. Aufgrund der vorgesehenen Ausnehmungen 68, 70 im Gehäusedeckel können auch in diesem Bereich in der Praxis oftmals Metallpartikel und insbesondere Fluidpartikel in störender Weise in das Innere des Akkupacks 10 eindringen.

Um dies zu verhindern, wird zur Abdichtung das Gummiformteil 80 mit seinen LED-Aussparungen 82 und seinem Schalterdom 84 auf den Schalter und die LEDs 86 der Leiterplatte 24 aufgesetzt und stellt im montierten Zustand mit dem Gehäusedeckel 16 eine zuverlässige Abdichtung bereit, wobei die LED-Anzeige, d.h. der Beleuchtungsstatus der einzelnen LEDs 86 durch die Aussparungen 82 des Gummiformteils 80 weiterhin nach außen sichtbar bleibt. So erkennt man in Figur 9, dass der Gehäusedeckel 16 in seinem Inneren Gehäusewandabschnitte 88 aufweist, die die Ausnehmungen 70 der Ladestandsanzeige im Gehäusedeckel 16 umgeben und das Gummiformteil 80 zuverlässig gegen die Leiterplatte 24 drücken, so dass der Übergangsbereich zwischen Gehäusedeckel 16 und Leiterplatte 24 im Bereich der Ladestandsanzeige 58 mittels des Gummiformteils 80 sicher abgedichtet ist. Gleiches gilt für den Bereich der Schalterausnehmung 68 im Gehäusedeckel 16.

Insgesamt ermöglicht die spezifische Gestaltung des Gehäuses des erfindungsgemäßen Akkupacks 10 zum einen eine Luftkühlung der darin aufgenommenen Akkuzellen, wodurch die Lebensdauer des Akkupacks signifikant erhöht wird. Zum anderen wird jedoch sichergestellt, dass mit der Kühlluft mitgeführte metallische Staubpartikel und/oder Luftfeuchtigkeit nicht in den Bereich der Pole der Akkuzellen gelangen und dadurch Kurzschlüsse und insbesondere eine Beschädigung des Akkupacks erreichen können. Auf diese Weise wird ein besonders langlebiges und robustes Akkupack bereitgestellt.

Eine weitere Besonderheit des dargestellten Akkupacks 10 ist in der Ausgestaltung der elektronischen Sicherung zu erkennen. Diese ist nicht wie in der Praxis üblich als in sich abgeschlossenen Zukaufteil in das Akkupack montiert, um die Leiterplatte 24 mit den Akkuzellen 20 zu verbinden, sondern umfasst ein elektrische leitfähiges Sicherungselement 60, das in einem Sicherungsbereich 64 (vgl. Figuren 5A und 6) innerhalb des Gehäuses des Akkupacks 10 eingehaust ist. Das Sicherungselement 60 ist durch ein einfaches Stanzteil aus Metall gebildet und über Verbindungsschrauben 62 mit einer Verbindungsschiene 56 der Leiterplatte 24 bzw. einem Leiterblech 22 des Akkupacks 10 verbunden. Im montierten Zustand des Gehäusedeckels 16 umgeben die äußeren Gehäusewände sowie innere Gehäusewände 66 des Sicherungsbereichs 64 das Sicherungselement 60 in der Weise, dass dieses (auf dem Zellenträger 12 über die Verbindungsschrauben 62 festgelegt) in einem inneren Gehäuse, dem Sicherungsbereich 64 eingehaust und somit vor eindringendem Metallstaub und Feuchtigkeit geschützt ist. Zugleich werden auch die umgebenden elektronischen Bauteile durch den Sicherungsbereich 64 vor abplatzenden Metallteilen des Sicherungselements 60 geschützt, wenn dieses im Überlastfall durchbrennt oder durchbricht.

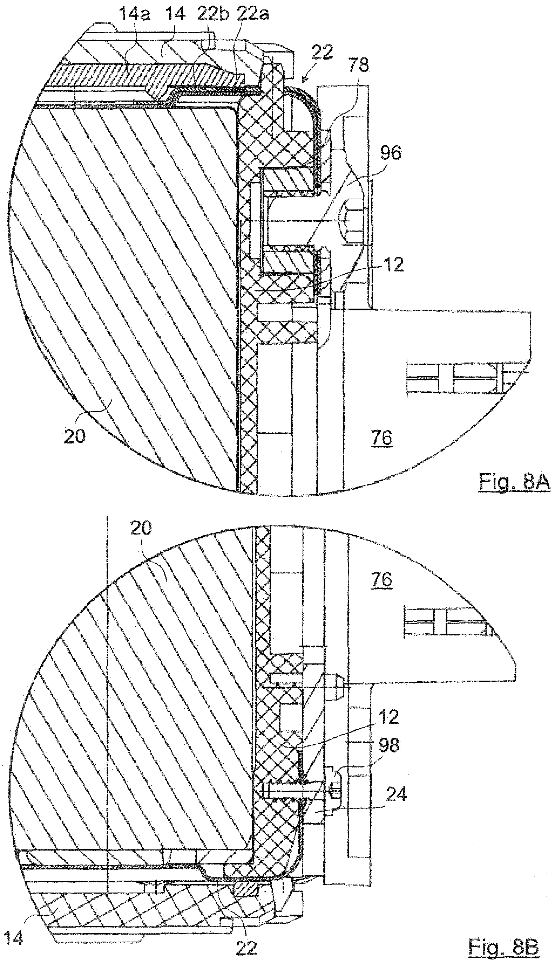

Eine weitere Besonderheit des Akkupacks 10 ist schließlich in der besonderen Ausbildung eines oder mehrere Leiterbleche 22, beispielsweise der Leiterbleche an Plus- und Minuspol der Akkuzellenreihenschaltung, zu erkennen. Anders als im Stand der Technik werden hier zwei Leiterblechlagen 22a und 22b angebracht, nämlich eine erste Leiterblechlage 22a und eine zweite Leiterblechlage 22b, die einander zumindest teilweise überlappen (vgl. Figuren 7 und 8A). So wird die erste Leiterblechlage 22a als einreihiges (kurzes) Leiterblech zur Verbindung mit den Akkuzellen 20 nur an die obere Akkuzelle 20 angeschweißt und die zweite Leiterblechlage 22b zur Verbindung mit den Akkuzellen 20 als zweireihiges (langes) Leiterblech (das einreihige Leiterblech 22a im Bereich der oberen Akkuzelle 20 überlappend) nur an die untere Akkuzelle 20 angeschweißt.

Auf diese Weise wird eine Erhöhung der Stromtragfähigkeit gegenüber den aus dem Stand der Technik bekannten Lösungen erreicht.

## Patentansprüche

1. Akkupack (10), insbesondere für ein Elektrohandwerkzeuggerät, mit: wenigstens zwei in Reihe oder parallel geschalteten Akkuzellen (20) und/oder Akkuzellenblöcken, einem Gehäuse mit einem Zellenträger (12) zur Aufnahme der Akkuzellen (20) und/oder Akkuzellenblöcke in übereinander angeordneten Reihen, und
einer Leiterplatte (24),
wobei die Akkuzellen (20) im montierten Zustand des Akkupacks (10) über Leiterbleche (22) mit der Leiterplatte (24) verbunden sind, und
wobei wenigstens eines der Leiterbleche (22) im montierten Zustand des Akkupacks mit der Leiterplatte (24) zumindest abschnittsweise wenigstens zwei Leiterblechlagen (22a, 22b) umfasst.

2. Akkupack (10) nach Anspruch 1,
wobei eine erste Leiterblechlage (22a) eine Akkuzelle einer ersten Reihe mit der Leiterplatte (24) verbindet, und wobei eine zweite Leiterblechlage (22b) eine Akkuzelle einer zweiten Reihe mit der Leiterplatte (24) verbindet.

3. Akkupack (10) nach Anspruch 1 oder 2,
wobei die Leiterblechlagen (22a, 22b) sich zumindest abschnittsweise überlappen.

4. Akkupack (10) nach einem der vorhergehenden Ansprüche,
wobei die Leiterblechlagen (22a, 22b) jeweils mit einer zugeordneten Ackuzelle (20) einer Reihe verschweißt sind.

5. Akkupack (10) nach einem der vorhergehenden Ansprüche,
wobei die Leiterblechlagen (22a, 22b) im Bereich der Verbindungsstelle mit der Leiterplatte (24) überlappend angeordnet sind.

6. Akkupack (10) nach einem der vorhergehenden Ansprüche,
wobei das wenigstens zweilagige Leiterblech (22) mittels einer Verbindungsschraube (62, 96) direkt oder indirekt mit der Leiterplatte (24) verbunden ist.

7. Akkupack (10) nach einem der vorhergehenden Ansprüche,
wobei die Akkuzellen (20) in Reihe geschaltet sind und das wenigstens zweilagige Leiterblech (22) im Bereich des Minuspols bzw. des Pluspols mit der Leiterplatte (24) verbunden ist.

8. Akkupack (10) nach Anspruch 7,
wobei das wenigstens zweilagige Leiterblech (22) im Bereich des Minuspols über eine Minusstromschiene (78) indirekt mit der Leiterplatte (24) verbunden ist und/oder wobei das wenigstens zweilagige Leiterblech (22) im Bereich des Pluspols über ein elektrisch leitfähiges Sicherungselement (60) indirekt mit der Leiterplatte (24) verbunden ist.

9. Elektrohandwerkzeuggerät mit einem Elektromotor sowie wenigstens einem hiermit lösbar verbindbaren Akkupack (10) nach einem der Ansprüche 1 bis 8, wobei wenigstens eine Schnittstelle zur mechanischen und elektrischen Verbindung des Akkupacks (10) mit dem Elektrohandwerkzeuggerät vorgesehen ist.
